# DEMANDE DE BREVET EUROPEEN

(11) **EP 1 326 286 A1**
(43) Date de publication de la demande: **09.07.2003**
(21) Numéro de dépôt: 02293060.6
(22) Date de dépôt: 11.12.2002
(51) Int. Cl.: H01L 31/042, H02J 7/35

(54) **Procédé de fonctionnement d'un module solaire photovoltaique et module solaire photovoltaique**

(30) Priorité: 14.12.2001 DE 10161480
(71) Demandeur: Saint-Gobain Glass France, 92400 Courbevoie (FR)
(72) Inventeur: Erban, Christof, 52134 Herzogenrath (DE)
(74) Mandataire: Muller, René

(57) **Abrégé**

Pour faire fonctionner des modules solaires avec une sécurité contre les manipulations non autorisées, il est proposé d'utiliser le circuit série de toute façon présent des cellules solaires pour le contrôle de grandeurs électriques (tensions, courants) qui sont caractéristiques de l'état de l'équipement concerné. Le circuit série peut, par exemple, former une portion d'une boucle de courant de repos dont l'interruption provoque le déclenchement d'une alarme ou alors on détecte une chute brutale de la puissance générée par procédé photovoltaïque pour déclencher une alarme.

## Description

L'invention se rapporte à un procédé de fonctionnement d'un module solaire photovoltaïque et aux modules solaires photovoltaïques.

Le nombre croissant d'équipements solaires constitués de modules solaires photovoltaïques fait accroître le risque de manipulation non autorisée, notamment du vol de telles pièces d'équipement qui, du fait de leur mode de fonctionnement, sont toujours exposées et parfois installées loin des habitations. Les dommages peuvent être considérables, car elles sont très chères.

Les mécanismes de protection antivol performants et sûrs sont chers et parfois compliqués à manipuler. Ils empêchent en outre toute manipulation, par exemple des opérations d'extension ou de remplacement par l'exploitant de l'équipement solaire.

Le brevet EP-B1-0 896 737 fait connaître un arrangement solaire photovoltaïque muni d'un dispositif de déconnexion intégré qui neutralise la puissance électrique du module lorsqu'il est activé par un dispositif de commande externe. Ce dispositif doit rendre inopérant le module solaire concerné s'il est démonté par une personne non autorisée, par exemple. Les manipulations à ce dispositif de déconnexion ne sont possibles qu'après avoir détruit l'ensemble du module. La même publication mentionne en introduction, sans citer de source, que des systèmes d'alarme pour modules solaires ont déjà été proposés qui peuvent être constitué, par exemple, d'une boucle électrique qui s'étend sur l'ensemble des modules solaires d'un équipement et qui peuvent déclencher un signal d'alarme en cas d'interruption.

Il est connu (par exemple DE-A1-34 05 564) d'appliquer par cuisson sur la surface de plaques en verre trempé des boucles conductrices faisant partie d'un circuit de courant de repos qui est interrompu en cas de destruction de la plaque en verre et qui déclenche une alarme par le biais d'un circuit d'analyse.

Il est connu que les modules solaires existants sont composés d'un assemblage de nombreuses cellules solaires individuelles branchées électriquement en série dans un élément de construction de grande surface. Plusieurs de ces modules solaires sont généralement branchés en série pour obtenir une puissance de sortie la plus élevée possible. Le résultat de ce branchement en série est la réalisation d'une boucle conductrice continue aux extrémités ou aux bornes de laquelle est prélevée la puissance électrique produite.

On connaît également des éléments solaires (DE-A1-42 08 469) dont les cellules solaires servent de capteurs pour mesurer le rayonnement solaire incident courant. La valeur détectée par ces cellules peut être utilisée, par exemple, pour représenter le rayonnement solaire incident momentané sur le module concerné au moyen d'indicateurs d'affichage.

La panne de certaines cellules solaires branchées en série ou le fait qu'elles se trouvent à l'ombre est partiellement compensé en pratique par des diodes dites de bipasse qui permettent au courant de contourner ces cellules. Un courant de court-circuit peut passer par la diode de bipasse lorsque la résistance interne de la cellule solaire concernée dépasse la chute de tension aux bornes de la diode.

L'invention a pour objet de réaliser un procédé de fonctionnement d'un module solaire qui permet de détecter avec certitude et à moindre coût les manipulations non autorisées au module et d'indiquer un module solaire équipé en conséquence.

Conformément à l'invention, cet objet est réalisé du point de vue du procédé par les caractéristiques de la revendication 1 et de la revendication indépendante 2 et, du point de vue du module solaire, par les caractéristiques des revendications 5 ou 7. Les caractéristiques des revendications secondaires respectivement associées aux revendications indépendantes indiquent des perfectionnements avantageux de ces objets. Les revendications 6 et 8 sont orientées sur des circuits série de plusieurs modules solaires comprenant au moins un module solaire équipé conformément à l'invention.

En partant du circuit série électrique traditionnel des cellules solaires d'un module solaire et, le cas échéant, aussi du circuit série de plusieurs modules solaires, l'invention propose selon une première variante de solution d'injecter un courant de mesure dans le circuit série des cellules solaires pendant le fonctionnement de l'équipement et de contrôler son passage. Toute interruption du circuit série peut être détectée de manière connue avec des moyens appropriés (de préférence électroniques) et être transformée en une alarme, le cas échéant aussi en l'activation d'autres dispositions de sécurité telles qu'un blocage mécanique. Pour des raisons de simplicité, l'événement sera toujours désigné dans ce qui suit (ainsi que dans les revendications) comme le déclenchement d'un signal d'alarme.

Il est entendu que l'injection dudit courant de mesure ne doit avoir aucun effet perturbateur sur la sortie électrique du module solaire concerné.

Au lieu de boucles d'alarme à prévoir, par exemple, sur les plaques de recouvrement des modules solaires ou sur leurs cadres, ce sont donc les éléments fonctionnels des modules à protéger qui forment euxmêmes une portion de la boucle d'alarme. Ladite interruption du circuit série ou la fin de la circulation du courant peut être détectée directement par des circuits appropriés quelconques. Aucune circulation permanente du courant n'est naturellement nécessaire à cet effet, car la détection des manipulations est également obtenue par une injection cyclique du courant de mesure. Une modification ou une interruption est ici détectée par le fait que le courant qui circule est inexistant ou très faible lors de la prochaine injection après un intervalle de temps pendant lequel le courant de mesure circulait sans perturbation.

Les grandeurs électriques caractéristiques de chaque module solaire ou d'un circuit série de modules solaires sont la tension de sortie et/ou le courant de sortie. Même en fonctionnement normal, celles-ci sont soumises à des variations plus ou moins importantes en fonction de l'incidence de la lumière, lesquelles sont cependant généralement constantes et relativement lentes. La tension générée ne chute pas brutalement si un nuage fait de l'ombre au module solaire ou au moment du crépuscule, par exemple. D'après une autre variante de solution conforme à l'invention, une manipulation non autorisée sur le module solaire peut être détectée indirectement à partir d'une variation de l'une de ces grandeurs qui est plus rapide ou plus brutale de celle qui est attendue pendant le fonctionnement normal. Il est dans ce cas inutile d'injecter un courant de mesure propre et un signal d'alarme est déclenché si la variation de la grandeur électrique est inadmissible ou diffère excessivement d'une valeur de seuil prédéfinie.

Une autre solution est offerte par le contrôle de la capacité de la boucle électrique formée par le module solaire ou du circuit série composé de plusieurs modules solaires. Une brutale modification de celle-ci peut également laisser supposer une manipulation ou une interruption du circuit série et provoquer le déclenchement d'une alarme.

Bien évidemment, les modes de fonctionnement ou les méthodes de contrôle mentionnés précédemment peuvent aussi être combinés entre eux à volonté.

L'avantage essentiel avec cette configuration et ce mode de fonctionnement des modules solaires est le fait que très peu d'interventions sont nécessaires dans les éléments de construction standard. Les circuits de détection et éventuellement les alimentations nécessaires peuvent en principe être installés au niveau des bornes extérieures des modules solaires, ce qui ne nécessite aucune intervention dans ces derniers. Il est en outre même possible d'adapter ultérieurement et à peu de frais des modules et des équipements solaires terminés qui se trouvent déjà en service au mode de fonctionnement conforme à l'invention.

Le type de construction des cellules solaires (cristallines, technologie à couche mince, etc.) est sans importance pour l'application de l'invention. Le résultat est qu'il est en outre possible non seulement de détecter les manipulations sur les modules, mais également d'utiliser ce contrôle des éléments de surface modulaires dans la protection du bâtiment. Les traversées non autorisées d'un mur qui est recouvert de modules solaires exploités ou équipés conformément à l'invention provoque également le déclenchement d'une alarme.

Et ce ne sont pas seulement les manipulations dérangeantes effectuées sur les modules solaires surveillés qui sont détectées, l'alarme peut également être déclenchée lors d'une déconnexion (non autorisée) de points de liaison (par exemple des connecteurs) du circuit série contrôlé. Le déclenchement d'une alarme peut toutefois également signaler une panne liée à un défaut sans manipulation étrangère.

Mais bien évidemment, il faut pouvoir empêcher le déclenchement de l'alarme par des dispositions de commande appropriées lorsque des personnes autorisées doivent réaliser des travaux d'entretien, de réparation ou de transformation sur l'équipement concerné.

D'autres particularités et avantages de l'objet de l'invention résultent du dessin d'un exemple de réalisation et de la description ci-après.

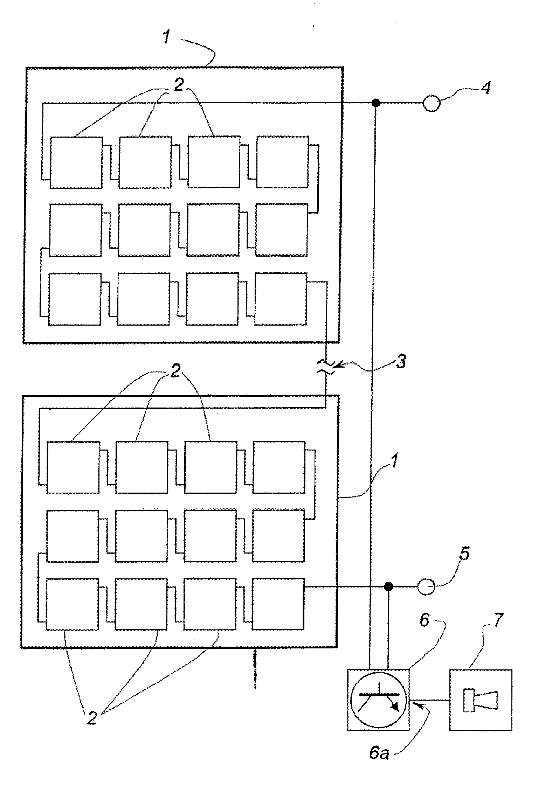

La figure 1 représente un synoptique simplifié d'une forme de réalisation d'un module solaire muni d'un circuit d'analyse. Une pluralité de cellules solaires 2 sont à chaque fois branchées entre elles en série de manière connue dans les modules solaires 1. Dans la majorité des applications ou des équipements, plusieurs modules solaires 1 de ce type sont à leur tour branchés électriquement en série afin d'obtenir des tensions de service de plusieurs centaines de volts. Deux modules solaires sont représentés ici. Des modules solaires supplémentairesnon illustrés ici - peuvent être intégrés dans le circuit série à un point de liaison 3 entre la borne de sortie du module solaire supérieur et la borne d'entrée du module solaire inférieur. Ces points de liaison peuvent également être réalisés de manière connue sous la forme de connecteurs avec lesquels les modules solaires peuvent s'emboîter les uns dans les autres et être reliés électriquement. Les câbles de liaison externes qui sont uniquement représentés ici pour des raisons de clarté deviennent donc inutiles.

L'ensemble du circuit série possède deux bornes de sortie 4 et 5 sur lesquelles est présente la tension de sortie de l'ensemble des modules solaires 1 pendant le fonctionnement ou desquelles est prélevée leur puissance électrique. Les diodes bipasse déjà mentionnées, qui peuvent être affectées aux cellules solaires individuelles ou à des groupes, ne sont pas représentées ici pour des raisons de simplification.

Les cadres tracés autour des modules solaires 1 symbolisent le fait que la totalité de leurs éléments de construction mentionnés, à l'exception de leurs bornes de sortie 4 et 5, peuvent être logés à l'intérieur d'une unité, les modules solaires pouvant ici être construits à l'identique.

Un circuit électronique d'analyse 6 muni d'une alimentation électrique interne ou externe (non illustrée) est à présent branché entre les deux bornes de sortie 4 et 5 par le biais de deux fils. Il est également envisageable que le circuit d'analyse 6 soit alimenté par une (petite) partie de la puissance photovoltaïque générée par les modules solaires 1 qu'il puisse éventuellement stocker à l'aide d'accumulateurs ou similaires pour les heures de faible luminosité. Son rôle et son mode de fonctionnement seront encore décrits plus en détail. Un générateur de signal 7 permettant de générer un signal d'alarme est dans tous les cas raccordé à une sortie 6a du circuit d'analyse 6. Il représente ici en même temps les autres mesures de sécurité mentionnées plus haut destinées à protéger l'équipement.

Le circuit d'analyse 6 peut injecter à intervalles réguliers un courant de mesure dans le circuit série composé des cellules solaires 2. Il peut s'agir, par exemple, d'un faible courant alternatif ou d'impulsions de courant individuelles périodiques qui sont superposés au courant solaire et qui peuvent être parfaitement distinguées de celui-ci. Un défaut ou une interruption du circuit série contrôlé peut être supposé si une impulsion injectée ne donne pas très vite lieu à une intensité de courant élevée correspondante. Le circuit d'analyse 6 peut alors immédiatement activer le générateur de signal 7.

Dans une autre configuration, le circuit d'analyse 6 comprend un composant différentiel qui permet de détecter les variations du courant ou de la tension photovoltaïque, éventuellement même la capacité de la boucle totale parallèle aux bornes de sortie 4 et 5. La variation à chaque fois présente est comparée avec une valeur de seuil prédéfinie. Le générateur de signal 7 est là aussi activé si la variation présente une différence inadmissible par rapport à ladite valeur de seuil. Cela permet également de détecter avec certitude une chute brutale de la puissance photovoltaïque pendant le fonctionnement provoquée par un défaut ou une interruption, au moins tant que la quantité de lumière incidente est suffisante pour produire du courant.

## Revendications

1. Procédé de fonctionnement d'un module solaire photovoltaïque comprenant une pluralité de cellules solaires branchées électriquement en série entre deux bornes de sortie et comprenant un dispositif de protection du module solaire contre les manipulations non autorisées, **caractérisé par**
- l'injection dans le circuit série d'un courant de mesure pouvant être différencié du courant généré par procédé photovoltaïque,
- l'analyse de l'intensité du courant de mesure dans un circuit d'analyse,
- le déclenchement d'un signal d'alarme lors de la détection d'une résistance supérieure à une valeur de seuil prédéfinie ou d'un affaiblissement de ladite intensité du courant de mesure au-dessous de son intensité de consigne.

2. Procédé de fonctionnement d'un module solaire photovoltaïque comprenant une pluralité de cellules solaires branchées électriquement en série entre deux bornes de sortie et comprenant un dispositif de protection du module solaire contre les manipulations non autorisées, **caractérisé par**
- la détection de la variation de l'une des grandeurs électriques caractéristiques présentes aux deux bornes de sortie,
- l'analyse de la variation dans un circuit d'analyse,
- le déclenchement d'un signal d'alarme par le circuit d'analyse en présence d'une variation desdites grandeurs électriques différente d'une valeur de seuil prédéfinie.

3. Procédé selon la revendication 2, **caractérisé en ce que** la détection s'applique à la variation de la tension générée par procédé photovoltaïque par le module solaire ou du courant produit.

4. Procédé selon la revendication 2 ou 3, **caractérisé en ce que** la détection s'applique à la variation de la capacité de la boucle formée par le circuit série.

5. Module solaire (1) comprenant une pluralité de cellules solaires (2) branchées électriquement en série ainsi qu'un circuit d'analyse, **caractérisé en ce que** des moyens sont prévus pour injecter un courant de mesure dans le circuit série des cellules solaires, le courant de mesure étant acheminé au circuit d'analyse, que le circuit d'analyse comprend des moyens pour détecter une résistance du circuit série supérieure à une valeur de seuil prédéfinie ou une variation de ladite intensité du courant de mesure, et qu'il est prévu au moins un générateur de signal (7) pouvant être activé par le circuit d'analyse (6).

6. Circuit série de modules solaires selon la revendication 5, chaque module solaire ou alors un ou plusieurs groupes de modules solaires ou encore tous les modules solaires étant exposés en commun à un courant de mesure qui peut être analysé dans au moins un circuit d'analyse.

7. Module solaire (1) comprenant une pluralité de cellules solaires (2) branchées électriquement en série ainsi qu'un circuit d'analyse, **caractérisé en ce que** le circuit d'analyse comprend des moyens pour détecter une grandeur électrique caractéristique variable du module solaire et ses variations ainsi que des moyens pour comparer les variations avec au moins une valeur de seuil prédéfinie, et qu'il est prévu au moins un générateur de signal (7) pouvant être activé par le circuit d'analyse (6).

8. Circuit série de modules solaires selon la revendication 7, dans lequel les grandeurs électriques caractéristiques variables de chaque module solaire individuel ou alors d'un ou de plusieurs groupes de modules solaires ou encore de tous les modules solaires peuvent être contrôlées en commun à l'aide du circuit d'analyse.
